# EUROPEAN PATENT APPLICATION

(11) **EP 2 608 263 A2**
(43) Date of publication of application: **26.06.2013**
(21) Application number: 12198391.0
(22) Date of filing: 20.12.2012
(51) Int. Cl.: H01L 29/10, H01L 29/36, H01L 29/739, H01L 29/66

(54) **A tunnel field-effect transistor and methods for manufacturing thereof**

(30) Priority: 21.12.2011 EP 11194802
(71) Applicant: IMEC, 3001 Leuven (BE)
(72) Inventor: Hantschel, Thomas, 3001 Leuven (BE); Verhulst, Anne S., 3001 Leuven (BE); Vandervorst, Wilfried, 3001 Leuven (BE); Huyghebaert, Cedric, 3001 Leuven (BE)
(74) Representative: Hertoghe, Kris Angèle Louisa

(57) **Abstract**

A tunnel Field Effect Transistor (1) is disclosed comprising an interface (4) between a source (2) and a channel (3), the source side of this interface being a layer (5) of a first crystalline semiconductor material (7) being substantially uniformly doped with a metal to the solubility level of the metal in the first crystalline material (7) and the channel side of this interface (4) being a layer (6) of this first crystalline semiconductor material (7) doped with this metal, the concentration decreasing with increasing distance from the interface (4).

## Description

### Field of the invention

The present invention relates to tunnel field effect transistors (TFET) where the drive current of the transistor is based on band-to-band tunnelling. Furthermore the invention relates to a method for manufacturing such tunnel field effect transistors.

### Background of the invention

Nanoelectronic devices, being electronic devices comprising features with a dimension below 1 µm, e.g. a dimension between 1 nm and 500 nm, such as a dimension between 3 nm and 300 nm, are generally fabricated using semiconductor materials and processing for manufacturing the integrated circuits. A complementary metal-oxide-semiconductor (CMOS) field effect transistor is one of the core elements of the integrated circuits. Dimensions and operating voltages of CMOS transistors are continuously reduced, or scaled down, to obtain ever-higher performance and packaging density of the integrated circuits.

One of the problems due to the scaling down of CMOS transistors is that the power consumption keeps increasing. This increase is partly because leakage currents are increasing, e.g. due to short channel effects, and partly because it becomes difficult to further decrease the power supply voltage. As the physical subthreshold swing for CMOS transistors is limited to about 60 mV/decade, a minimal power supply voltage will be needed to switch the transistor from the OFF state to the ON state.

Tunnel field-effect transistors (TFETs) are typically advertised as successors of metal-oxide semiconductor field-effect transistors (MOSFETs), because of their absence of short-channel effects and because of their resulting low off-currents. Another advantage of TFETs is that their theoretical subthreshold swing can be less than 60 mV/dec, the physical limit of conventional MOSFETs, thereby offering the potential of operating at lower supply voltages compared to CMOS transistors.

However, homostructure TFETs, with channel and source/drain regions formed from the same material, typically suffer from either low on-currents, such as e.g. all-silicon TFETs, i.e. with channel and source/drain regions formed in silicon, in which case this drawback is related to the large resistance of the larger tunnel barrier of silicon, or they suffer from high off-currents, such as e.g. all-indiumarsenide TFETs, i.e. with channel and source/drain regions formed in indiumarsenide, in which case this drawback is related to the low resistance of the tunnel barrier at the drain contact at which location an ambipolar current is generated. Heterostructure TFETs, i.e. with different semiconductor materials for the source and at least a part of the channel, are promising as they combine a high on-current (Iₒₙ) due to efficient tunneling at the source-channel region with a low off-current (I_{off}) due to inefficient tunneling at the channel-drain region. However, for such heterostructure TFET's an average subthreshold swing of less than 60 mV/dec for reasonable Iₒₙ/I_{off} values has not been achieved yet.

Theoretical studies show that an in two dimensions tip-shaped source region with a uniform shape in the third dimension such that the shape of the source/channel junction is constant along the width of the channel, is beneficial to improve the subthreshold swing. For example Yue Yang et al. report in an article in "Extended abstracts of the 2010 International Conference on Solid State Devices and Materials (SSDM)", page 798-799, entitled "Drive current enhancement with invasive source in double gate tunneling field-effect transistors" simulation results for a Ge TFET structure comprising an invasive p+ source structure, wherein this p+ region in the middle of the channel extends under the gate. This structure results in an increased tunneling region and as such also in a higher on-current Iₒₙ.

P. F. Wang, K. Hilsenbeck, Th. Nirschl, et al. reports in Solid-State Electronics 48, p. 2281 (2004) simulation results indicating higher source doping levels and steeper source doping profiles may result in a higher on-current Iₒₙ and thus in an improved subthreshold swing for a given off-current I_{off}.

However, no manufacturable process flow has been disclosed for manufacturing TFET devices having a high on-current Iₒₙ, a low leakage current I_{off} and a subthreshold swing less than 60 mV/dec.

Hence there is a need for methods to manufacture such TFET devices which overcome the disadvantages mentioned above for state of the art TFETs.

### Summary of the invention

It is an object of embodiments of the present invention to provide a method for manufacturing a tunnel Field Effect transistor (TFET) with good device properties; in particular a TFET with good performance, e.g. improved performance compared to prior art TFET devices. Such TFET according to particular embodiments of the present invention may have an average subthreshold swing below 60 mV/dec corresponding to a high on-current Iₒₙ and/or a low off-current I_{off}, even at reduced power supply voltage. The on-current Iₒₙ may be above 100 micro-ampere/micrometer (µA/µm) while the off-current I_{off} may be below 1 nano-ampere/micrometer (nA/µm). The supply voltage may be 1 V or less

It is an object of embodiments of the present invention to provide a method for manufacturing such a TFET comprising cost-effective and easy process steps which can be applied in the manufacturing of different types of TFET devices such as for example: vertical or horizontal TFETs, homo- or heterostructure TFETs, NanoWire-based TFET devices (NW-TFETs),...

It is an object of embodiments of the present invention to provide tunnel Field Effect transistor (TFET) with good device properties. Such tunnel TFETs may for instance be TFETs with a subthreshold swing below 60 mV/dec, a high on-current Iₒₙ and low off-current I_{off} even at reduced power supply voltage, e.g. 1 V or less.

The above objectives are accomplished by methods and devices according to embodiments of the present invention.

Particular and preferred aspects of the invention are set out in the accompanying independent and dependent claims. Features from the dependent claims may be combined with features of the independent claims and with features of other independent claims as appropriate and not merely as explicitly set out in the claims.

In a first aspect, the present invention provides a tunnel Field Effect Transistor (TFET) comprising an interface between a source and a channel. At the source side of this interface, a layer of a first crystalline semiconductor material is present which is substantially uniformly doped with a metal at a doping level close to, e.g. substantially equal to, such as equal to, but anyway lower than the solubility level of the metal in the first crystalline material. At the channel side of this interface, a layer of this first crystalline semiconductor material doped with this metal is present, the concentration of the metal decreasing with increasing distance from the interface. Provided the profile is steep, hence the decrease of the concentration with distance goes fast, there is a steep subthreshold swing. A high doping level, close to the solubility level of the metal in the first crystalline material, results in a high on-current. A low off-current may be obtained by properly manufacturing the drain region.

In a transistor according to embodiments of the present invention, the source side interface layer may be further substantially uniformly doped with another dopant at a first concentration level and the channel side interface layer may be doped with this another dopant, the concentration thereof decreasing from this first concentration level with increasing distance from the interface.

The another dopant for p-type dopants may be selected from the group of B, Al, Ga, In, Tl, Pd, Na, Be, Zn, Au, Co, V, Ni, MO, Hg, Sr, Ge, Cu, K, Sn, W, Pb, O, Fe, and for n-type dopants may be selected from the group of Li, Sb, P, As, Bi, Te, Ti, C, Mg, Se, Cr, Ta, Cs, Ba, S, Mn, Ag, Cd, Pt.

In a transistor according to embodiments of the present invention, the source side interface layer may have a thickness between 5 nm and 100 nm and the concentration level of the metal and/or the another dopant may be at least 1e19/cm³.

In a transistor according to embodiments of the present invention, the channel side interface layer may have a thickness between 5 nm to 100 nm and a concentration gradient between 10 nm/dec to 1 nm/dec. The thickness of the channel side interface layer should be at least such that the layer is not fully depleted in the gate-voltage range of interest. Hence the thickness depends on the obtained doping, which in turn is limited by the solubility limit of the dopant in the semiconductor material: the higher the doping, the thinner the layer can be.

In a transistor according to embodiments of the present invention, the interface may be in a plane, for example a {111} plane. If the interface is not in a plane, it may be formed by a set of planes which all are {111} planes.

In particular embodiments, the source may protrude towards and into the channel. Such structure results in an increased tunneling region and as such also in a higher on-current Iₒₙ.

The transistor according to embodiments of the present invention may be a vertical type tunnel field effect transistor or a horizontal type tunnel field effect transistor.

The first crystalline semiconductor material from which at least source and channel are formed may be the semiconductor material of a semiconductor-on-insulator substrate.

In a transistor according to embodiments of the present invention, the channel may further comprise a layer of a second crystalline semiconductor material adjacent to the channel side of the first crystalline semiconductor material and possibly adjacent to the channel side of the interface layer.

In a transistor according to embodiments of the present invention, the source may further comprise a layer of an alloy of the first crystalline semiconductor material and the metal, the alloy layer contacting the source side interface layer.

In a transistor according to embodiments of the present invention, the first crystalline semiconductor material may for example be SiₓGe₁₋ₓ with 0 ≤ x ≤1.

The metal may for example be Aluminum. Aluminum is particularly advantageous as it forms a eutectic system with both silicon and germanium. This eutectic property is required to get the crystalline layer at the pyramidal sidewall.

A second aspect of the present invention is related to a method for manufacturing a tunnel field effect transistor (TFET).

A method according to embodiments of the present invention comprises:
- providing a first crystalline semiconductor material,
- providing a layer of a metal, in contact with the first crystalline semiconductor material where a source is to be formed,
- forming the source and part of the channel by forming a layer of an alloy of the metal and the first crystalline semiconductor material, thereby forming an interface between the source and the channel, and forming at the source side of the interface and in contact with the alloy a layer of the first crystalline semiconductor material substantially uniformly doped with the metal up to the solubility level of the metal in the first crystalline material, and forming at the channel side of the interface a layer of this first crystalline semiconductor material doped with this metal, the concentration of the metal in the layer decreasing with increasing distance from the interface.

A method according to embodiments of the present invention may comprise providing a drain region in a semiconductor substrate, providing a channel region in the semiconductor substrate in contact with the drain region thereby forming a drain-channel interface with the drain region, providing a source region in contact with the channel region thereby forming a source-channel interface with the source region having a highly doped source-channel interface, e.g. with a dopant level of 1e19 at/cm³ or higher. In particular embodiments the source region may locally protrude into the channel region. The source region may locally have a tip-shaped protrusion into the channel region.

Providing the source region may comprise providing a metal layer in contact with the channel region offset from the drain-channel interface, forming from the metal layer and from part of the semiconductor channel region in contact with the metal, a metal-semiconductor alloy, for example protruding into the channel region thereby forming a shaped source-channel interface having at least one tip along the source-channel interface. The metal-semiconductor alloy comprises metal material from the deposited metal layer and semiconductor material from the channel region and further also comprises a highly doped, e.g. at a doping level of 1e19 at/cm³ or higher, shaped semiconductor layer at the shaped source-channel interface.

In accordance with embodiments of the present invention, the layer of metal may comprise another dopant. In such embodiments, the method may comprise, when forming the source side interface layer and the channel side interface layer, doping these interface layers with this another dopant such that the source side interface layer is substantially uniformly doped with this another dopant at a first concentration level and the channel side interface layer is doped with this another dopant, the concentration thereof decreasing from the first concentration level with increasing distance from the interface.

The another dopant may be, for p-type dopants, selected from the group of B, Al, Ga, In, Tl, Pd, Na, Be, Zn, Au, Co, V, Ni, MO, Hg, Sr, Ge, Cu, K, Sn, W, Pb, O, Fe, and for n-type dopants, selected from the group of Li, Sb, P, As, Bi, Te, Ti, C, Mg, Se, Cr, Ta, Cs, Ba, S, Mn, Ag, Cd, Pt.

The thickness of the interface layers is typically between and including 100 nm to 5 nm, for example between and including 15 nm and 5 nm.

The interface layer at the source side of the interface may have a dopant concentration (of both metal and another dopant together) at least higher than 1e19/cm³, for example higher than 1e20/cm³. The interface layer at the channel side of the interface has a concentration gradient between 10 nm/dec to 1 nm/dec, for example 5 nm/dec indicating the concentration drops with 1 decade per 5 nm.

The metal-semiconductor alloy forms very sharp interfaces with the surrounding semiconductor material, i.e. with abrupt transitions from the metal-semiconductor alloy to semiconductor channel region. The shape of the metal-semiconductor alloy may follow particular crystal planes of the semiconductor material of the channel region such that a pyramidal shape is obtained. The shape of the source-channel junction is determined by the crystalline orientation of the semiconductor material of the channel region as the metal-semiconductor alloy will grow anisotropically in a crystal-orientation dependent way.

The shape of the metal-semiconductor alloy may be a tip shape or a wedge shape. Thus the shaped metal-semiconductor alloy may be a tip-shaped or wedge-shaped metal-semiconductor alloy protruding into the channel region thereby respectively forming a tip-shaped or wedge-shaped source-channel interface whereby the interface is at an angle with the surface of the gate in contact with the channel region.

The metal used is selected from the group of metals which forms an eutectic system with the semiconductor material. This eutectic system may result in a tip-shaped or wedge-shaped alloy within the semiconductor material. This metal can also be a dopant of the semiconductor material. In particular embodiments, this metal can be doped with a dopant of the semiconductor material. An example of such a material combination is Aluminium and Silicon, whereby Boron, being a p-type dopant for Silicon, can be introduced into the Aluminium.

The method for manufacturing a TFET may further comprise, at least partly, removing the metal-semiconductor alloy without removing the highly doped shaped semiconductor layer thereby leaving a opening. The method can further comprise providing a source contact on the highly doped shaped semiconductor layer in the opening. In particular embodiments, the opening may be pyramidal shaped.

According to embodiments of the present invention forming the shaped metal-semiconductor alloy comprises performing a heat treatment, causing the metal to interact with the semiconductor material to form an eutectic alloy thereby creating the shaped source-channel interface, and thereafter cooling down, thereby solidifying the shaped source-channel interface resulting in the formation of highly doped semiconductor layers sandwiched between the alloy and the original semiconductor material.

According to embodiments of the present invention, the metal layer may be doped with a dopant which dopant, after the formation of the alloy, will be present in the highly doped sandwiched semiconductor layers.

The thickness of the metal layer may range from a few nanometres, for example 10 nm, up to 1 micrometer.

The metal layer may be provided using techniques such as sputtering, chemical vapour deposition, evaporation, screen printing,....

The metal content in the alloy is limited by the solubility of the metal in the semiconductor material. For example, when Aluminum(Al) is used as metal material, the Al-content in the alloy layer is limited by the solubility of Al in Si, which implies that it maximally amounts to about 10¹⁹ at/cm³.

The concentration of the dopant, which may be added to the metal layer, should be maximized, as to reach the solubility limit of the dopant in the semiconductor material. This solubility limit typically corresponds to a few times 10²⁰ at/cm³. This is considered a very high doping in TFET. For example the metal layer may be doped with Boron (B), which implies that the concentration of B in this metal layer should be increased to reach the solubility limit of Boron in the semiconductor (Si), which typically corresponds to a few times 10²⁰ at/cm³.

The concentration of the dopant in the semiconductor material can be lower than in the doped metal material providing the dopants.

In particular embodiments, but non-limiting, metal-semiconductor combinations for the present invention, are Al-Si or Al-Ge, wherein the Aluminum is doped with for example Boron.

According to embodiments of the present invention a method for manufacturing a tunnel field effect transistor is provided, the method comprising: forming a drain region, forming a source region, forming a channel region comprising a semiconductor material in between the source region and the drain region, the interface between the source region and the channel region being shaped, more particularly for example being tip-shaped or wedge-shaped, and the interface between the drain region and the channel region being for instance planar, forming a gate stack, comprising a gate dielectric and a gate electrode, which gate stack at least contacts part of the channel region, wherein forming the source region comprises: depositing a metal layer, for example an Aluminum layer, on at least part of the semiconductor material of the channel region, forming a shaped metal-semiconductor alloy between deposited metal and semiconductor material of the channel region, the metal-semiconductor alloy protruding into the channel region thereby forming the shaped source-channel interface comprising a highly doped semiconductor layer in the source region, at least partly removing the metal-semiconductor alloy without removing the highly doped semiconductor layer thereby leaving a tip-shaped opening, and providing a source contact in the tip-shaped opening.

In case of a method for forming a horizontal TFET semiconductor device, depositing the metal layer on part of the channel region further comprises providing an opening in the semiconductor layer offset from the channel-drain interface and filling the opening with metal of the metal layer.

In embodiments of the present invention, providing a first crystalline semiconductor material may comprise providing a semiconductor-on-insulator substrate whereby the first crystalline semiconductor material is the semiconductor material of the semiconductor-on-insulator substrate.

In embodiments of the present invention, providing a first crystalline semiconductor material may include providing the first semiconductor material on a layer of a second crystalline semiconductor material, this layer being part of the channel.

The first crystalline semiconductor material may for example be SiₓGe₁₋ₓ, with 0 ≤ x ≤ 1.

The embodiments of the present invention are applicable to all types of TFET implementations, including but not limited to planar TFETs, double-gate TFETs, tri-gate TFETs such as like FinFETs, and all-around TFETs, horizontal and vertical TFET implementations, including implementations with a bulk contact and without a bulk contact.

The embodiments of the present invention are furthermore applicable to all TFETs independent of the type of channel doping, including p-type channel doping, n-type channel doping and intrinsic doping.

The embodiments of the present invention furthermore applicable to all TFET implementations, independent of the semiconductor material used as source material, as channel material and as drain material, including TFETs with a source material which is different from the channel material and/or which is different from the drain material, including TFETs with a drain material which is different from the channel material. Possible semiconducting materials are including but not limited to group IV materials such as Si, Ge, C or binary compounds thereof, or group III/V materials such as In, Ga, As, Sb, Al, P, B, N or binary, tertiary or quaternary compounds thereof or group II/VI materials such as Cd, Zn, S, Se, Te, O or binary, tertiary or quaternary compounds thereof, or carbon nanotubes.

The embodiments of the present invention are furthermore applicable to all TFET implementations, independent of the gate dielectric material and thickness. Possible gate dielectric materials are. including but not limited to, silicon based oxides e.g. silicon dioxide, silicon oxy nitride, aluminium oxide, high-k oxides such as oxides, nitrided oxides, silicates and nitrided silicates of transition metals such as Hf, Ta, Ti, Nb, V, Y, Zr.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

The high performance achieved for TFET devices according to this invention is an advantage compared to state-of-the-art TFET devices. In particular the high performance refers to a very high on-current and a steep subthreshold swing, i.e. less than 60 mV/dec, which allows decreasing the power supply voltage, and hence allowing for a low-power device such that scaling of the transistor can be continued beyond the capabilities of the MOSFET.

### Brief description of the drawings

The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Figures 1-5 illustrate various TFETS according to embodiments of the present invention.

Figures 6a-j illustrate by means of schematic top views and corresponding cross sections A-A a method of manufacturing of a vertical tunnelFET manufactured according to embodiments of the present invention.

Figure 7 show a schematic cross section of a vertical heterostructure tunnel FET according to an embodiment of the present invention.

Figures 8a-h illustrate by means of schematic top views and corresponding cross sections A-A a method of manufacturing a horizontal tunnel FET according to embodiments of the present invention.

Figure 9 shows a schematic cross section of a horizontal tunnel FET manufactured according to another embodiment of the present invention.

Figures 10a and 10b show respectively a top view and the corresponding schematic cross section A-A of a horizontal tunnel FET manufactured according to another embodiment of the present invention.

In the drawings, the same reference signs refer to the same or analogous elements.

**Table 1: overview of reference numbers used**

| | | | |
|---|---|---|---|
| 1 | tunnel Field Effect Transistor | 2 | Source |
| 3 | Channel | 4 | Interface between source and channel |
| 5 | Source side interface layer | 6 | Channel side interface layer |
| 7 | first crystalline semiconductor material | 8 | Protrusion towards channel |
| 9 | Layer of second crystalline semiconductor material | 10 | Second crystalline semiconductor material |
| 11 | metal | 12 | Alloy of metal 11 and first crystalline semiconductor material 7 |
| 13 | layer of alloy 12 | 14 | layer of metal 11 |
| 15 | source electrode | 16 | drain |
| 17 | gate dielectric | 18 | gate electrode |
| 19 | drain electrode | 20 | trench |

### Detailed description of illustrative embodiments

The present invention will be described with respect to particular embodiments and with reference to certain drawings but the invention is not limited thereto but only by the claims.

Moreover, the terms top, bottom, over, under and the like in the description and the claims are used for descriptive purposes and not necessarily for describing relative positions. It is to be understood that the terms so used are interchangeable under appropriate circumstances and that the particular embodiments described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this invention, in one or more embodiments.

Similarly it should be appreciated that in the description of exemplary particular embodiments, various features of the invention are sometimes grouped together in a single embodiment, figure, or description thereof for the purpose of streamlining the disclosure and aiding in the understanding of one or more of the various aspects. This method of disclosure, however, is not to be interpreted as reflecting an intention that the claimed invention requires more features than are expressly recited in each claim. Rather, as the following claims reflect, aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that particular embodiments may be practiced without these specific details. In other instances, well-known methods, structures and techniques have not been shown in detail in order not to obscure an understanding of this description.

The invention will now be described by a detailed description of several particular embodiments. It is clear that other particular embodiments can be configured according to the knowledge of persons skilled in the art without departing from the technical teaching of the invention as defined by the appended claims.

All figures are intended to illustrate some aspects and particular embodiments of the present invention. The figures are depicted in a simplified way for reason of clarity. Not all alternatives and options are shown and therefore the invention is not limited to the content of the given drawings. Like numerals are employed to reference like parts in the different figures.

When referring to the term tunnelling field effect transistor (TFET) through the text, reference is made to a semiconductor device in which the gate controls the source-drain current through modulation of the so-called Band-To-Band Tunnelling (BTBT). Band-to-band tunnelling is a physical mechanism in which electrons tunnel from the valence band through the semiconductor bandgap to the conduction band or vice versa. A TFET comprises typically a source-channel-drain configuration wherein the source and drain region are oppositely doped, i.e. for example the source region is p-type doped whereas the drain region is n-type doped or vice versa. The channel region is lower doped than source and drain regions or is undoped.

While some embodiments described herein include examples of a double-gate TFET device, more specifically a TFET device comprising a horizontal source-channel-drain structure and a double gate electrode situated at least on the sidewalls of the channel region of the horizontal source-channel-drain structure, also other implementations of TFET devices may be applied such as for example a tri-gate TFET, an all-round gate TFET, a nanowire TFET,.... A tri-gate TFET comprises a horizontal source-channel-drain structure and a triple gate electrode situated on the sidewalls and on top of the channel and/or source region of the horizontal source-channel-drain structure. An all-around TFET comprises a horizontal or a vertical source-channel-drain structure and an all-around gate electrode situated around the channel and/or source region of the horizontal or vertical source-channel-drain structure. A nanowire TFET comprises a nanowire which forms at least the channel region and an all-around gate electrode structure around the channel and/or source region of the nanowire TFET. More specifically the fabrication method according to embodiments of the present invention relates to but is not limited to standard planar technology, double gate technology, finfet technology and nanotechnology, wherein the latter includes implementations with integrated nanowires.

While some embodiments described herein include examples of a nTFET, which means the semiconductor device comprises a p-type source, a channel contacted by a gate electrode, and a n-type drain, such a nTFET being often referred to as a p-i-n diode TFET, also other implementations of TFET devices may be applied such as for example a pTFET, which means the semiconductor device comprises an n-type source, a channel contacted by a gate electrode, and a p-type drain.

Whenever reference is made in the present disclosure to a particular dopant type, this is done for the ease of explanation only and is not intended to limit the invention. It is to be understood that in the examples given herein below, materials and dopant types may be replaced by other suitable materials and dopant types, without changing the scope of the invention.

Whenever reference is made to the solubility level, this refers to that doping level above which clusters start to form if a dopant is added to a crystalline material. Such clusters may break the crystallinity of the material and is hence not wanted.

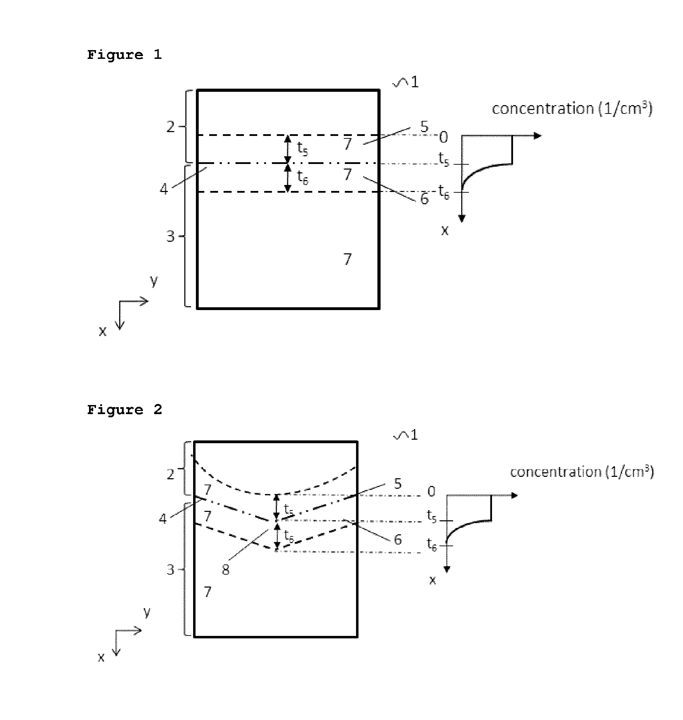

Figures 1-5 illustrate various embodiments of the present invention by means of schematic cross sections.

Figure 1 shows a tunnel Field Effect Transistor 1 according to embodiments of the present invention, comprising an interface 4 between a source 2 and a channel 3. At the source side of this interface 4 is a layer 5 of a first crystalline semiconductor material 7 substantially uniformly doped with a metal 11 at a level below, up to and close to, e.g. not lower than 10% below, or not lower than 5% below, or not lower than 1% below the solubility level of the metal 11 in the first crystalline material 7. At the channel side of this interface 4 is a layer 6 of this first crystalline semiconductor material 7 doped with this metal 11, the concentration thereof decreasing towards the channel.

Optionally, the source side interface layer 5 is furthermore substantially uniformly doped with another dopant such that a total concentration level of metal dopants and the another dopant is obtained, indicated hereinafter N₅, and the channel side interface layer 6 is then doped with this another dopant, the total dopant concentration level in this channel side interface layer 6 decreasing from this concentration level N₅ towards the channel 3. Adding the another dopant may be done in order to increase the on-current of the TFET. For the example of silicon doped with Al, Al has a solubility limit of 1e19 at/cm³ in Si. If it is desired to obtain a higher doping, for example, but not limited thereto, up to 1e20 at/cm³, another dopant may be added.

Typically the source side interface layer 5 has a thickness t₅ between 5 nm and 100 nm and a (substantially constant) concentration level N₅ of at least 1e19/cm³. The channel side interface layer 6 has typically a thickness t₆ between 5 nm to 100 nm and a concentration gradient of the dopants between 10 nm/dec to 1 nm/dec.

The plane of the interface 4 may be a {111} plane. In figure 1 the interface 4 is substantially planar, in which case the {111} plane is lying in the y-z plane parallel to the substrate. Figure 1 illustrates a vertical type Field Effect Transistor.

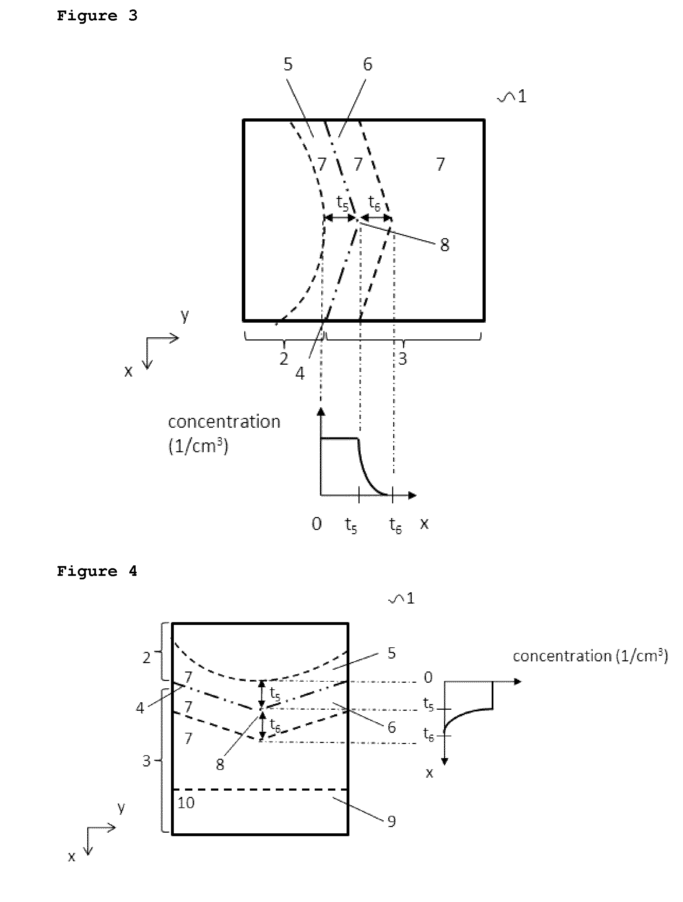

However, as illustrated by figure 2, the source 2 can protrude towards and into the channel 3 thereby forming a pyramidal-like structure 8 into the channel 3. The sidewalls of this protrusion 8 form the interface 4 and are lying in a {111} plane. Figure 2 shows a vertical type of a Field Effect Transistor 1 wherein the source 2 protrudes into the channel 3 along the x direction. Figure 3 shows a horizontal type of such a Field Effect Transistor 1 wherein the source 2 protrudes into the channel 3 along the y direction.

In the tunnel Field Effect Transistors 1 illustrated by figures 1 to 3, the source 2 and channel 3 are formed from the same crystalline semiconductor material 7. Such a TFET is known as homostructure TFET. As illustrated by figure 4, in embodiments of the present invention, the channel 3 can further comprise a layer 9 of a second crystalline semiconductor material 10 adjacent to the channel side of the first crystalline semiconductor material 7 and possibly adjacent to the channel side of the interface layer 6 resulting in a heterojunction between the first crystalline semiconductor material 7 and the second crystalline semiconductor material 10. Such a TFET is known as heterostructure TFET.

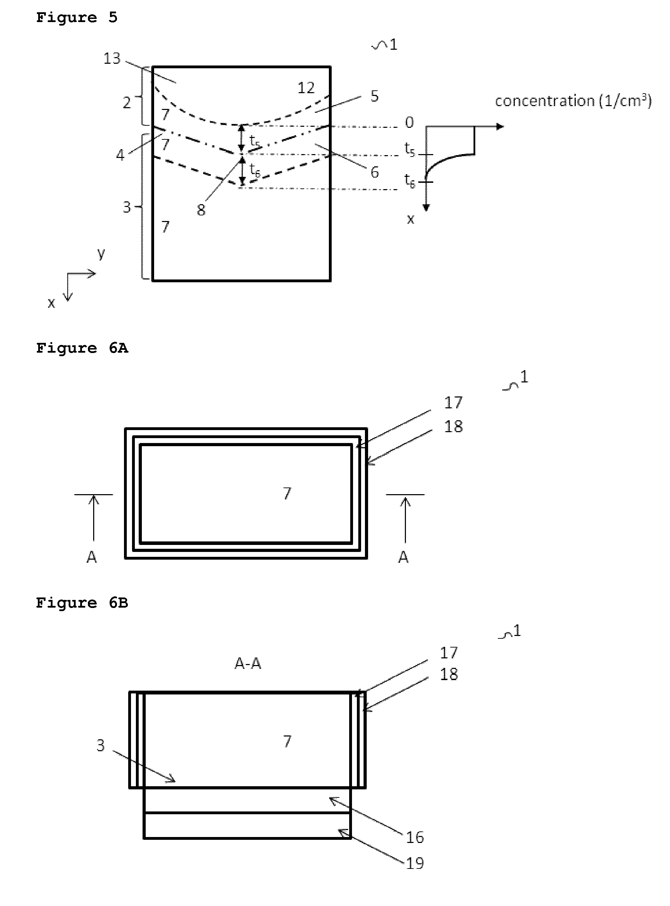

As shown by figure 5, in embodiments of the present invention, the source 2 of the tunnel Field Effect Transistors 1 illustrated by figures 1 to 4 can further comprise a layer 13 of an alloy 12 of the first crystalline semiconductor material 7 and the metal 11, the alloy layer 12 contacting the source side interface layer 5.

In particular embodiments, the first crystalline semiconductor material 7 may be SiₓGe₁₋ₓ with 0 ≤ x ≤ 1. In particular embodiments, the metal 11 may be Aluminium. If this Aluminium 11 is doped with another dopant, preferably this another dopant is Boron, and this another dopant will become a dopant of the source side interface layer 5 and the channel side interface layer 6.

In an aspect of the present invention methods for manufacturing the source-channel interface of a tunnel field effect transistor are disclosed.

For the purpose of teaching, embodiments of the present invention will now be described for a vertical TFET structure, the present invention, however, not being limited thereto.

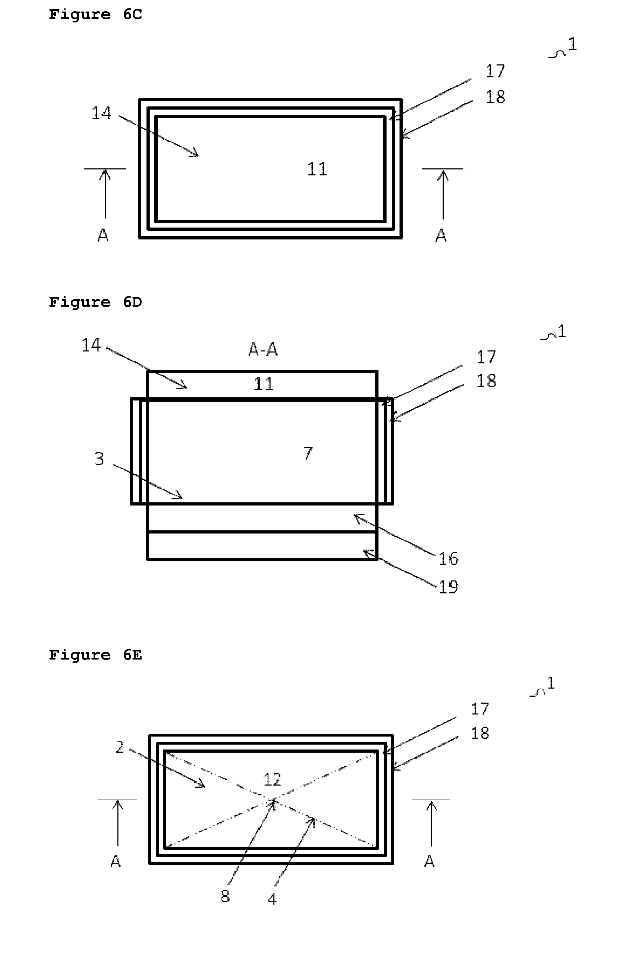

Figures 6a to 6j show schematic representations of the top view and corresponding schematic representations of the cross-section AA of a vertical TFET structure comprising a pyramidal shaped source region 3 according to embodiments of the present invention, during different manufacturing steps.

First a substrate (not illustrated) is provided. In particular embodiments, this substrate may be a crystalline semiconductor substrate such as a silicon substrate or a semiconductor-on-insulator (SOI) substrate but any other suitable substrate supporting a crystalline semiconductor layer 7 can be used as well, such as, for example, glass, ceramics, etc.

According to methods known for a person skilled in the art, a drain 16 and channel 3 are provided on the semiconductor substrate as shown in figures 6a and 6b. The channel 3 is in contact with the drain 16. For example, the drain 16 and the channel 3 may be formed by epitaxial growth of semiconductor material 10,7 of the drain 16 and channel 3 on the semiconductor substrate or layer. Alternatively nanostructures may be etched from an undoped substrate after which the bottom region of the thus formed nanostructure is implanted thereby forming the doped drain 16.

The drain 16 may be made of a semiconductor material which is highly n-doped in case of an n-type TFET, or alternatively in case of a p-type TFET the drain 16 is highly p-doped. In embodiments of the present invention, the doping level of the drain 16 is typically in the range of 1e18/cm³ to 1e21/cm³, for example in the range of 1e19/cm³ to 5e20/cm³.

In embodiments of the present invention, the channel 3 can be made of a semiconductor material 7, 10 which is the same or different from the semiconductor material of the drain 16, thereby forming respectively a homojunction or heterojunction between the channel 3 and the drain 16. The channel 3 may for example be undoped or at least lower doped than the drain 16, e.g. having a dopant concentration level which is at least a factor 10 lower than the dopant concentration level of the drain 16. In embodiments of the present invention, the doping level of the channel 3 may be in the range of undoped up to 1e17/cm³ doping, for example in the range of undoped up to 1e15/cm³ doping.

According to particular embodiments, a gate comprising agate dielectric 17 and gate electrode 18,is provided as shown in figures 6a and 6b. The gate, more specifically the gate dielectric 17 of the gate 10, is at least in contact with the channel 3 of the TFET device 1. In the embodiment illustrated in figures 6a and 6b, the gate is an all-around gate, covering the circumference of the channel 3. In alternative embodiments, the device could for instance be a double-gate device, with the gate only covering two sides of the circumference of the channel, or a tri-gate device, with the gate covering three sides of the circumference of the channel.

According to particular embodiments, the crystalline semiconductor substrate has a [100] orientation. Then a shaped source 2 is provided in contact with the channel 3 as such forming a tip-shaped source-channel interface 4 between the source 2 and the channel 3. Otherwise said, the interface 4 between the source 2 and the channel 3 is not a plane but has a tip-like shape 8, as illustrated in the cross-sections of any of figures 2 to 5. With tip-like shape is meant that the source 2 has a pyramidal shape with the tip 8 extending into the channel region or that the source 2 has a knife-edged shape with the knife edge 8 extending into the channel region or that the source 2 has a conical shape with an apex 8 extending into the channel region or that the source 2 has a conical shape with a knife-edge apex 8 extending into the channel region. The source 2 is formed by a plurality of layers. The first layer is a layer 5 of the first crystalline semiconductor material 7 of which also the channel is made, substantially uniformly doped with a metal 11. This first layer 5 may furthermore be doped with another dopant as set out above.

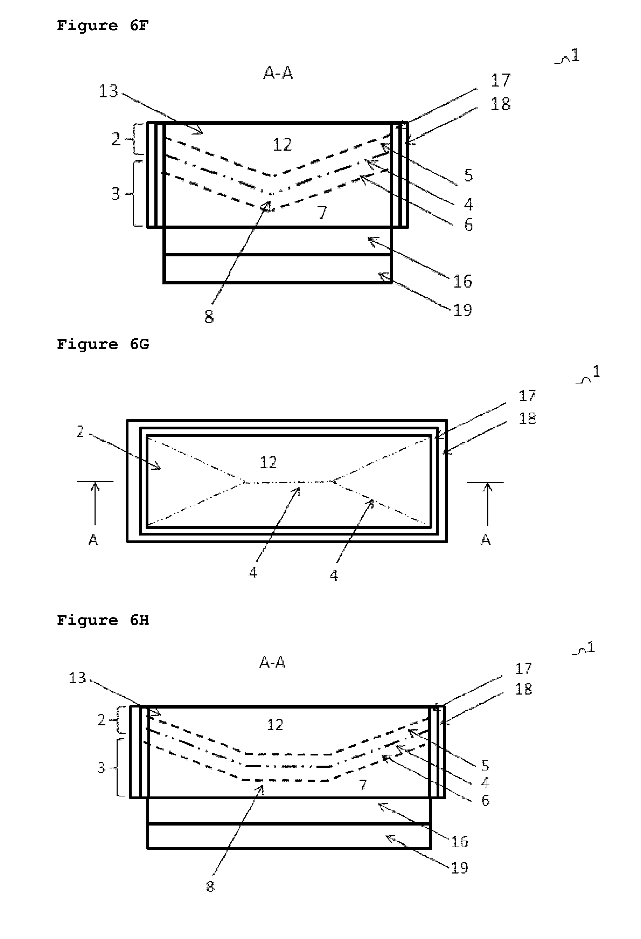

Depending on the shape of contact area between the layer 14 of the alloying metal 11 and the source 2, the alloy formed 12 may be pyramidal shaped or knife-edge shaped resulting in a shaped source 2. Figures 6e and 6f illustrate a pyramidal shaped source region 3 having 1 apex. The contact area between the metal layer 14 and the source region 3 was square. Figures 6g and 6h illustrate a knife-shaped source region having 2 apexes. Here the contact area between the metal layer 11 and the source region 3 was rectangular.

According to embodiments of the present invention, the channel 3, after the step of providing a channel 3 in contact with the drain 16, has a cuboid shape with a rectangular top surface which is substantially parallel to the semiconductor substrate surface plane. The sidewalls of the cuboid channel are substantially orthogonally oriented with respect to the semiconductor substrate surface plane. A channel having a cuboid shape with a rectangular top surface is also referred to as a rectangular cuboid channel 3.

According to embodiments of the present invention, the channel 3, after the step of providing a channel 3 in contact with the drain 16, has a cuboid shape with a square top surface which is substantially parallel to the semiconductor substrate surface plane. The sidewalls of the cuboid channel are substantially orthogonally oriented with respect to the semiconductor substrate surface plane. A channel 3 having a cuboid shape with a square top surface is also referred to as a square cuboid channel 3.

According to embodiments of the present invention, the channel 3, after the step of providing a channel 3 in contact with the drain 16, has a cylindrical shape with an elliptical top surface which is substantially parallel to the semiconductor substrate surface plane. The curved sidewall of the cylindrical channel is substantially orthogonally oriented with respect to the semiconductor substrate surface plane. A channel 3 having a cylindrical shape with an elliptical top surface is also referred to as an elliptic cylindrical channel.

According to embodiments the channel 3, after the step of providing a channel 3 in contact with the drain 16, has a cylindrical shape with a circular top surface which is substantially parallel to the semiconductor substrate surface plane. The curved sidewall of the cylindrical channel 3 is substantially orthogonally oriented with respect to the semiconductor substrate surface plane. A channel 3 having a cylindrical shape with a circular top surface is also referred to as a circular cylindrical channel.

A layer of metal 11 is provided on top of the first crystalline semiconductor material 7 in which the channel 3 is formed and the source 2 is to be formed. There is a crystal-orientation dependent formation, whereby the dissolution of dopants is easier in one direction than in another direction. As an example dissolution of Al in Si is much easier in the {111} planes, and hence a pyramidal shape consisting of 4 {111} planes is obtained. Upon cooling down, the eutectic system is responsible for the Al-doped Si crystalline formation. As the dissolution rate of Al in Si is strongly dependent on the crystal planes (lowest dissolution rate is for {111}-plane due to the highest packing density), anisotropic behaviour is achieved and shapes similar to anisotropic wet etching are created.

In the case of a rectangular cuboid channel 3, the source 2 will be knife-edge pyramidal shaped.

In the case of a square cuboid channel 3, the source 2 will be pyramidal shaped.

In the case of an elliptic cylindrical channel 3, the source 2 will be knife-edge shaped, wherein the dimensions of the ellipse will determine the length and width of the shape.

In the case of a cylindrical channel 3, the source 2 will be pyramidal shaped.

An advantage of the technique in accordance with embodiments of the present invention is that in the undoped region surrounding the part of the source protruding into the channel, no defects have been generated (e.g. typically defects are generated by implantation damage or by dislocations, which are not present here). Defects typically cause worse subthreshold swing, as they allow for current to flow when band-to-band tunnelling is not yet possible. Hence embodiments of the present invention provide a good, e.g. better than in prior art, subthreshold swing.

Figures 6a and 6b show a tunnel FET 1 comprising a cuboid channel 3 in contact with a drain 16 on a drain electrode 19. On the channel 3, a gate stack is provided comprising a gate dielectric 17 and a gate electrode 18.

The step of providing a source 2 in contact with the channel 3 as such forming a tip-shaped source-channel interface 4 with the channel 3 comprises different substeps.

As shown in figures 6b and 6c a layer 14 of a metal 11 is provided on top of the first crystalline semiconductor material 7 in which the source 2 and the channel 3 are to be formed. The metal layer 14 may for example consist of an Aluminium layer. The metal layer 14 is provided on the surface of the crystalline semiconductor material 7 of the channel 3 which is exposed after the step of providing the channel 3. Providing the metal 11 may comprise depositing a metal layer 14 over the whole structure, i.e. the channel 3 and gate stack 17-18, and patterning the metal layer 14 such that the metal 11 remains only present on top of the channel 3 and in contact with the first crystalline semiconductor material 7. The metal layer 14 may be deposited using physical vapour deposition (PVD) or sputtering, chemical vapour deposition, screen printing,.... The thickness of the as-deposited metal layer 14 is in the range of 10 nm up to 1 micrometer.

According to embodiments a doped metal layer 14 may be provided in contact with the channel 3. The metal 11 of layer 14 may be doped with a p-type dopant, called a further dopant hereinabove, such as for example Boron. The metal 11 may be doped with an n-type dopant, such as for example As. For example a doped Aluminium layer may be provided. The Aluminium layer may be doped with a p-type dopant, such as for example Boron, resulting in an Al-B layer. The Aluminium layer may be doped with an n-type dopant, such as for example As, resulting in an Al-As layer. The dopant of the metal 11 is selected in view of the dopant level and dopant type of the interface layers 5, 6 that are to be formed as will be discussed further on.

If a source-channel interface 4 with a tip 8 is to be formed, the metal 11 must consist of a material which has a self-formation of a shape, e.g. tip or wedge-shape, in the host lattice, i.e. first crystalline semiconductor material 7, upon alloying, i.e. heat treatment and cooling down, and which may be, but not necessarily is a dopant of the host lattice. The metal layer is selected to form a semiconductor alloy in an anisotropic way. For example for a Si channel the following p-type dopants may be used: B, Al, Ga, In, Tl, Pd, Na, Be, Zn, Au, Co, V, Ni, MO, Hg, Sr, Ge, Cu, K, Sn, W, Pb, O, Fe. For example for a Si channel the following n-type dopants may be used: Li, Sb, P, As, Bi, Te, Ti, C, Mg, Se, Cr, Ta, Cs, Ba, S, Mn, Ag, Cd, Pt. For example for a Ge channel the following p-type dopants may be used: B, Al, Tl, Ga, In, Be, Zn, Cr, Cd, Hg, Co, Ni, Mn, Fe, Pt. For example for a Ge channel the following n-type dopants may be used: Li, Sb, P, As, S, Se, Te, Cu, Au, Ag.

After providing the metal layer 14, a shaped metal-semiconductor alloy 12 is formed by alloying the metal material 11 of the layer 14 with the semiconductor material 7 of the channel 3, as shown in figures 6e and 6f for a tip-shaped alloy 12 or 6g and 6h for a wedge-shaped alloy 12. The tip-shaped metal-semiconductor alloy 12 comprises metal material 11 from the as-deposited metal layer 14 and first crystalline semiconductor material 7 from the semiconductor channel 3 and also comprises a tip-shaped highly doped semiconductor layer 5 at the tip-shaped source-channel interface 4, the tip-shaped metal-semiconductor alloy 12 protruding 8 towards and penetrating into the channel 3 thereby forming the tip-shaped source-channel interface 4.

Forming the metal-semiconductor alloy 12 comprises performing a heat treatment and thereafter cooling down. The maximum temperature at which the heat treatment is performed may depend on the first crystalline semiconductor material 7. For silicon 7 the heat treatment is at least at 650°C, typically at 800°C, but can be higher than 800°C. For Germanium 7 the heat treatment is at least at 450°C but can be higher. A rapid thermal annealing step may be used for example. For example an Al-Si 12, 7 alloy may be formed by first heating the structure comprising the as-deposited Aluminium layer 14 on top of the Si channel 3. During this heating step the first crystalline semiconductor material 7, i.e. the silicon 7 from the channel 3 will dissolve into the Aluminium 11 of the layer 14. When the Al-Si 11,7 dissolved structure is then cooled down, several layers are formed, more specifically an Al-Si matrix layer (replacing the as-deposited Aluminium layer 14) in contact with an Al-Si alloy 12 (which penetrates into the original silicon channel 3). This Al-Si alloy 12 contacts a thin layer 5 being a highly metal 11 doped crystalline semiconductor layer 5 at the interface 4 and a lower metal doped crystalline semiconductor layer 6 at the opposite side of the interface 4. During the step of cooling down the doped semiconductor layers 5 and 6 are formed first. The remaining liquid solidifies at the eutectic temperature leading to the Al-Si alloy 12. The rest of the material forms a matrix layer of Al-Si particles. During the cooling down the Al concentration near the source-channel interface 4 is reduced leaving a highly doped semiconductor source side interface layer 5 and a lower doped semiconductor channel side interface layer 6.

Due to the fact that the alloy 12 formation starts from a square-like contact area, the resulting metal-semiconductor alloy 12 and doped semiconductor layers 5,6 formed at the surface of this metal-semiconductor alloy 12 has a pyramidal shape with the point of the pyramid protruding towards the channel 3. The pyramidal shape is obtained due to the different dissolution speeds which occur at different crystallographic planes, for example at the {100}and {111} planes.

In "Local Al-alloyed contact for next generation Si solar cells" from Uruena et al. as published on the 24th European Photovoltaic Solar Energy Conference, September 2009, the thermodynamics which lies behind the Al-Si alloy formation, more specifically the physical mechanism of the formation of so called Al-BSF, is described in more detail, hereby incorporated by reference.

The resulting structure after forming the metal-semiconductor alloy is schematically shown in figures 6e and 6f in case of a rectangular cuboid channel 3. After a heat treatment and cooling down of the structure, a tip-shaped source 2 is formed, the tip-shaped source 2 comprising a tip-shaped highly doped semiconductor interface layer 5 at the channel-source interface 4 and a tip-shaped metal semiconductor alloy 12 in contact with the tip-shaped highly doped semiconductor interface layer 5. The tip-shaped source 2 is protruding in the as-formed channel 3, such that the apex or end point of the tip-shaped source 2 is located in the as-formed channel 3. The resulting channel 3 becomes thus smaller than the as-formed channel 3 due to the penetration of the metal-semiconductor alloy 12 into the channel 3 and formation of the highly doped semiconductor interface layer 5 from the tip-shaped source region 3. Optionally a source electrode 15 can be formed on the alloy 12.

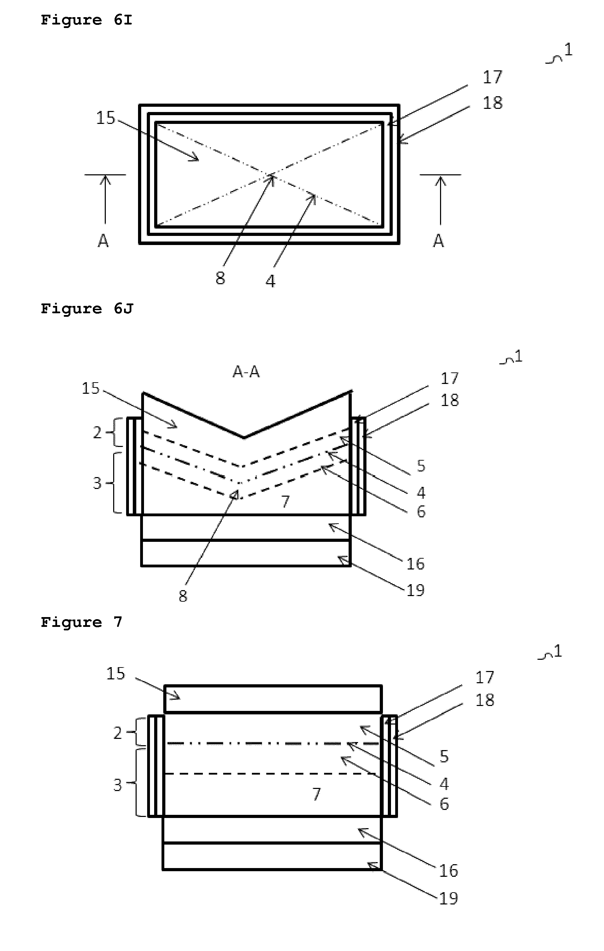

Alternatively, according to embodiments of the present invention at least part of, or even the complete semiconductor-metal alloy 12 may be removed. Figures 6i and 6j show a schematic representation of the resulting structure after complete removal of the semiconductor-metal alloy 12 and formation of the source electrode 15. The tip-shaped source 2 then consists of only the highly doped semiconductor layer 5. Alternatively, part of the metal-semiconductor alloy 12 may still be present. By completely removing the metal-semiconductor alloy 12 a tip-shaped opening is formed. The tip-shaped opening may be filled completely or partially with a source contact material as shown in figures 6i and 6j. Otherwise, on top of the tip-shaped source 2, i.e. highly doped semiconductor layer 5 or semiconductor-metal alloy 12 if not completely removed, a source electrode 15 may be formed.

Due to the self-formation of the source 2 comprising the highly doped semiconductor layer 5 a very sharp transition in doping level is formed from the highly doped source 2 toward the lower doped channel 3. Depending on the crystal orientation of the semiconductor substrate, this source 2 also comprises a tip 8 extending towards the channel 3. Otherwise said, an abrupt interface 4 may be formed between the source 2 and the channel 3 of the TFET structure 1.

Figure 7 illustrates a vertical tunnel FET where a highly doped source side interface layer 5 is formed at the interface 4 between the source 2 and the channel 3. Here the source 2 is flat without an apex 8 pointing towards the channel 3. Whereas in the previous embodiments, for the purpose of teaching the invention, a silicon substrate having a [100] crystal orientation was chosen, here a silicon substrate having a {111} crystal orientation is chosen for illustrating this embodiment having a planar interface 4. If a metal layer, such as an Aluminium layer 14 is deposited on the channel 3, a metal-semiconductor alloy 12 is formed when heating up and cooling down the substrate. Due to the {111} crystal orientation the Al-Si alloy 12 will grow uniformly into the first crystalline semiconductor substrate 7 resulting in a planar interface 4. As discussed above, also here the alloying metal layer 14 can be doped; either during providing this metal 11 or afterwards using ion implantation. In this embodiment, the semiconductor alloy 12 is completely removed and an additional source electrode 15 is contacting this highly doped source side interface layer 5. The semiconductor alloy 12 was formed by the interaction between the metal 11 provided to crystalline semiconductor material 7 wherein the channel 3 is to be formed.

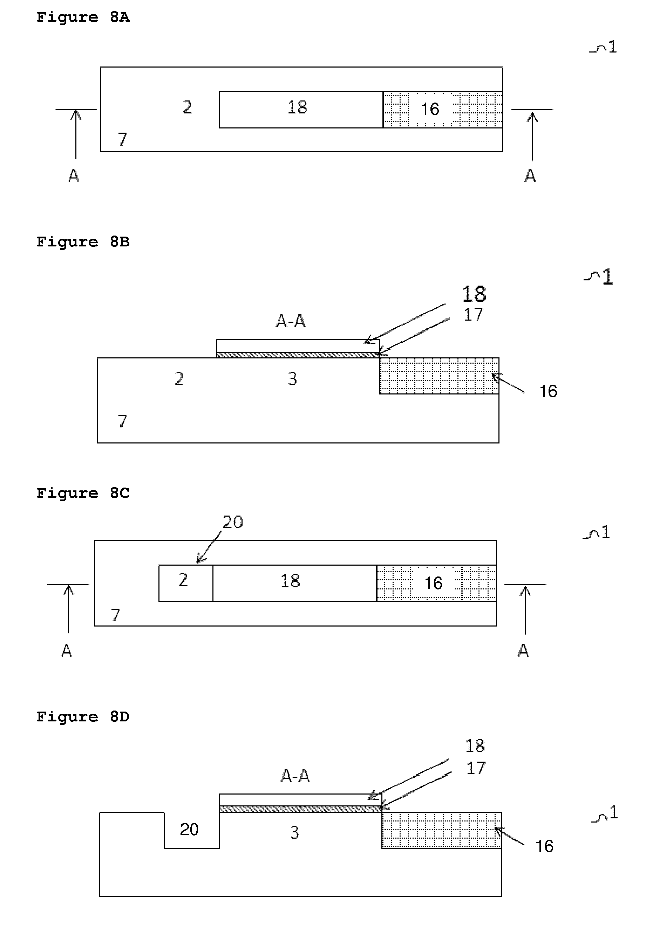

As an example different embodiments of the present invention are illustrated in figures 8a-h, showing schematic top views and corresponding cross sections A-A, describing methods for manufacturing a horizontal TFET structure with a shaped source-channel interface 4.

Figures 8a-8h show different steps of the top view and corresponding cross-sectional view A-A of a horizontal TFET device manufactured according to embodiments of the present invention.

Figure 8a and figure 8b schematically show a semiconductor 7 substrate wherein a drain 16 and gate stack 17, 18 are formed. The location of the source 2 and the channel 3 is indicated.

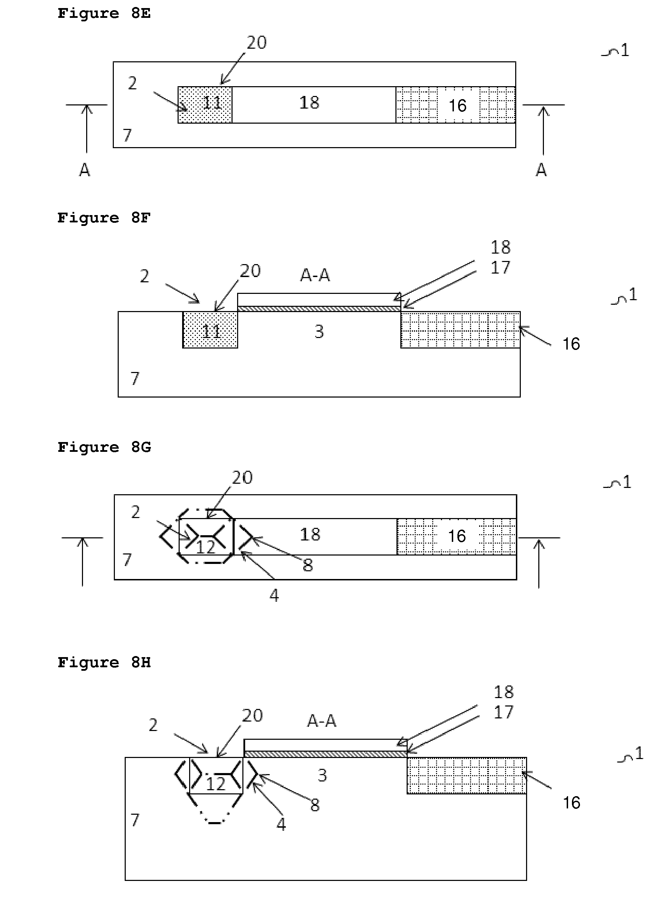

Figure 8c and figure 8d schematically show providing an opening 20 in semiconductor 7 substrate at the location of the source 2. This opening 20 is thereafter filled with the alloying metal 11 as shown in figures 8e and 8f. The opening, in the example illustrated, has a rectangular cross-section in a direction parallel to the plane of the substrate 7.

Thereafter, as shown in figures 8g and 8h, a shaped source 2 is formed in contact with the channel 3 as such forming a shaped source-channel interface 4. The shaped source 2 and the interface layers 5, 6 are formed as described above in detail by forming a metal-semiconductor alloy 12. The interface layers 5, 6 at the border between the semiconductor metal alloy 12 and the semiconductor material 7, from which the alloy 12 is formed, are not shown in figures 8g and 8h.

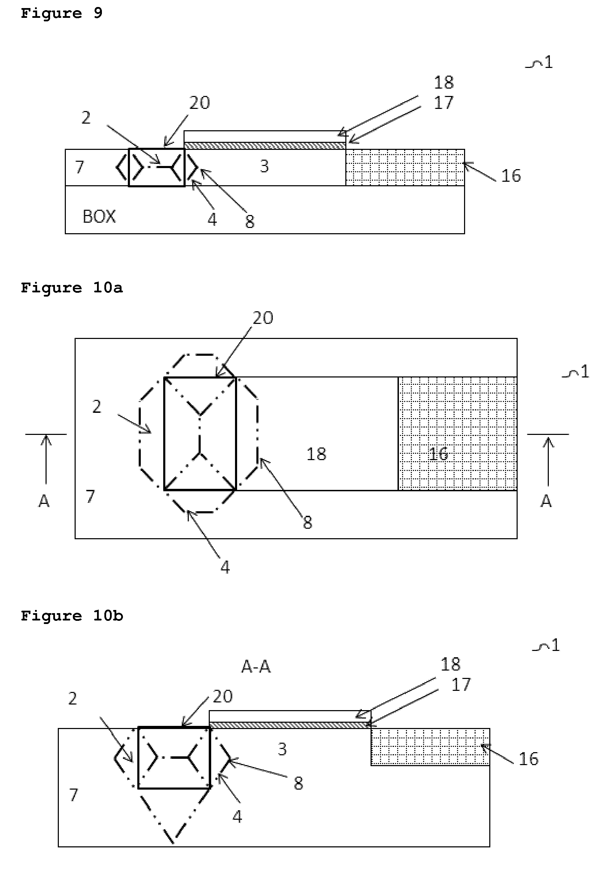

Figure 9 schematically shows a schematic cross section of an alternative embodiment wherein the semiconductor substrate comprises an SOI substrate. The semiconductor layer of the semiconductor-on-insulator substrate is used as the first crystalline semiconductor material 7. The underlying insulator layer is illustrated in figure 9 and indicated BOX. The yet underlying substrate layer is not illustrated in the drawings. The trench 20 in the semiconductor substrate at the location of the source 2 is in this case formed, and thereafter filled with the metal 11, down to the semiconductor-oxide interface of the SOI substrate, i.e. down to the so-called buried oxide layer BOX of the SOI substrate. In this embodiment no tip is formed pointing towards the underlying substrate as the buried oxide prevents this.

As disclosed in the embodiments related to the vertical tunnel FET, the shape of the source 2 depends on the shape of the contact area between the layer 14 of the alloying metal 11 and the source 2. For a horizontal tunnel FET, this contact area is determined by the dimensions of the opening 20 formed in the semiconductor 7 substrate. When a square opening is formed, the shaped source 2 will resemble a pyramidal shape as illustrated in figures 8a to 8h. When a more rectangular opening is formed, the shaped source 2 will more resemble a wedge shape.

As disclosed in the embodiments related to the vertical tunnel FET, the shape of the source 2 depends on shape of the contact area between the layer 14 of the alloying metal 11 and the source 2. For a horizontal tunnel FET, this contact area is determined by the dimensions of the vertical side planes of the opening 20 formed in the semiconductor 7 substrate. When a square vertical side plane of the opening is formed, the shaped source 2 will resemble a pyramidal shape as illustrated in figures 8a to 8h. When a more rectangular vertical side plane of the opening is formed, the shaped source 2 will more resemble a wedge shape. The latter embodiment is illustrated in figures 10a and 10b. Figure 10b show the cross section A-A of figure 10a. Only the interface 4 is indicated in these figures.

## Claims

1. A tunnel Field Effect Transistor (1) comprising an interface (4) between a source (2) and a channel (3), wherein at the source side of this interface (4) a layer (5) of a first crystalline semiconductor material (7) is present which is substantially uniformly doped with a metal (11) close to the solubility level of the metal (11) in the first crystalline material (7) and wherein at the channel side of this interface (4)a layer (6) of this first crystalline semiconductor material doped with this metal (11) is present, the concentration of the metal (11) decreasing with increasing distance from the interface (4).

2. The transistor (1) of claim 1, wherein the source side interface layer (5) is further substantially uniformly doped with another dopant at a total first concentration level (N₅) of metal (11) and the another dopant and the channel side interface layer (6) is doped with this another dopant, the dopant concentration in the channel side interface layer (6) decreasing from this first concentration level (N₅) with increasing distance from the interface (4).

3. The transistor (1) of any of the previous claims, wherein the interface is formed by a set of planes which all are {111} planes.

4. The transistor of claim 3, wherein the source (2) protrudes towards and into the channel (3).

5. The transistor of claim 3, wherein the interface (4) is substantially planar.

6. The transistor of any of the foregoing claims, wherein the channel (3) further comprises a layer (9) of a second crystalline semiconductor material (10) adjacent to the channel side of the first crystalline semiconductor material (7) and possibly adjacent to the channel side of the interface layer (6).

7. The transistor of any of the foregoing claims, wherein the source (2) further comprises a layer (13) of an alloy (12) of the first crystalline semiconductor material (7) and the metal (11), the alloy layer (13) contacting the source side interface layer (5).

8. A method for manufacturing a tunnel Field Effect Transistor (1) comprising an interface (4) between a source (2) and a channel (3),
the method comprising:
- providing a first crystalline semiconductor material (7),
- providing a layer (14) of a metal (11), in contact with the first crystalline semiconductor material (7) where a source (2) is to be formed,
- forming the source (2) and part of the channel (3) by forming a layer (13) of an alloy (12) of the metal (11) and the first crystalline semiconductor material (7), thereby forming an interface (4) between the source (2) and the channel (3),and forming at the source side of the interface (4) and in contact with the alloy (12) a layer (5) of the first crystalline semiconductor material (7) substantially uniformly doped with the metal (11) close to the solubility level of the metal (11) in the first crystalline material (7), and forming at the channel side of the interface (4) a layer (6) of this first crystalline semiconductor material (7) doped with this metal (11), the concentration of the metal (11) in the layer (6) decreasing with increasing distance from the interface (4).

9. The method of claim 8, wherein the layer (14) of metal (11) comprises another dopant, the method comprising, when forming the source side interface layer (5) and the channel side interface layer (6), doping these interface layers (5,6) with this another dopant such that the source side interface layer (5) is substantially uniformly doped with this another dopant at a first concentration level (N₅) and the channel side interface layer (6) is doped with this another dopant, the concentration thereof decreasing from the first concentration level (N₅) with increasing distance from the interface (4).

10. The method of any of the claims 8 or 9, wherein forming an interface (4) between the source (2) and the channel (3) includes forming an interface (4) consisting of a set of planes which are all {111} planes.

11. The method of claim 10, wherein forming the source (2) includes forming the source (2) such that it protrudes towards and into the channel (3).

12. The method of claim 10, wherein forming an interface (4) between the source (2) and the channel (3) includes forming the interface (4) according to a substantially planar plane.

13. The method of any of the claims 8 to 12, wherein providing a first crystalline semiconductor material (7) includes providing the first semiconductor material (7) on a layer (9) of a second crystalline semiconductor material (10), this layer (9) being part of the channel (3).

14. The method of any of the claims 8 to 13, further comprising at least partly removing the metal-semiconductor alloy (12).

15. The method of claim 14, further comprising, after at least partly removing the metal-semiconductor alloy (12), forming an electrode (15) contacting the source (2).
